# EUROPEAN PATENT APPLICATION

(11) **EP 1 959 454 A2**
(43) Date of publication of application: **20.08.2008**
(21) Application number: 08009242.2
(22) Date of filing: 26.09.2006
(51) Int. Cl.: G11C 13/00, G11C 16/02

(54) **Unipolar resistance random access memory (RRAM) device and vertically stacked architecture**

(30) Priority: 12.12.2005 US 301869
(62) Divisional of application: 06254982.9
(71) Applicant: Hitachi Global Storage Technologies Netherlands B.V., 1076 AZ Amsterdam (NL)
(72) Inventor: Stipe, Barry Cushing, San Jose, CA 95135 (US)
(74) Representative: Calderbank, Thomas Roger

(57) **Abstract**

One embodiment of the present invention includes a low-cost unipolar rewritable variable-resistance memory device, made of cross-point arrays of memory cells, vertically stacked on top of one another and compatible with a polycrystalline silicon diode.

## Description

This invention relates generally to the field of solid state (or non-volatile) ultra-low-cost mass storage device (or memories) based on a low current, vertically-stacked unipolar resistance random access memory (RRAM) and in particular, to a three-dimensional (3-D) cross point arrangement of memory cells forming a ultra-low-cost solid state memory or mass storage device made of low-current vertically-stacked unipolar RRAM.

Today, three-dimensional programmable read-only memories (PROMs) based on polycrystalline silicon (poly-Si) diodes and write-once antifuses, are gaining notoriety in commercial applications having the advantage of being less expensive than the current low-cost leader in rewritable solid state memory, i.e. two bit-per-cell NAND flash. For further details regarding this subject matter, the reader is referred to "512 Mb PROM With 8 Layers of Antifuse/Diode Cells", M. Crowley et al., 2003 IEEE International Solid-State Circuits Conference, paper 16.4 (2003) and to "Vertical p-i-n Polysilicon Diode with Antifuse for Stackable Field-Programmable ROM", S. B. Herner et al., IEEE Electron Device Letters, vol. 25, pp. 271-273 (2003). However, these vertically stacked memories have limited application because they cannot be rewritten. Also, only one bit-per-cell can be stored because the antifuse is either blown or not-blown.

By way of brief background, different types of non-volatile or solid state memory will be discussed. In phase change memory (PCRAM), the high and low resistance states of a phase-change resistor (amorphous versus crystalline) is used for storing bits. Typically, this programmable resistor is used in series with a diode or transistor to form a memory cell. PCRAM writing is accomplished by passing high current through the resistor to bring the material to the crystallization temperature or melting temperature (about 400 to 600 C). Rapid cooling of the melted material results in the amorphous (high resistance) phase. Writing the crystalline phase requires a longer time for nucleation and growth to occur (about 50 nanoseconds (ns)) and results in about 100 times lower resistance than in the amorphous phase. With the proper current or pulse duration, intermediate resistance values (partially crystallized material) can be obtained. For example if the materials resistance is controlled to fall within four resistance ranges, each memory cell can store two bits in much the same way that two-bit-per-cell flash memory uses four ranges of transistor threshold voltage to store two bits. Phase change memory may be categorized as a type of unipolar RRAM but it is referred to as PCRAM or PRAM or Ovonic Universal Memory (OUM). Because PCRAM is unipolar, a diode can be used to steer current through the cell in a manner similar to that used for 3D PROMs that use an anti-fuse. However, PCRAM is not compatible with this architecture for two main reasons. First, poly-silicon diodes require about 750 C during fabrication, a temperature at which typical phase change materials are unstable. Second, PCRAM requires a current density of at least 10⁶ A/cm² during reset (melting), which is a higher current density than can be supplied by poly-silicon diodes. For further details regarding this subject, the reader is referred to "Current Status of the Phase Change memory and its Future", S. Lai, International Electron Devices Meeting (IEEE), pp. 10.1.1-4 (2003). Many other types of variable resistance memories can be found in the literature but have similar incompatibilities with poly-silicon diodes.

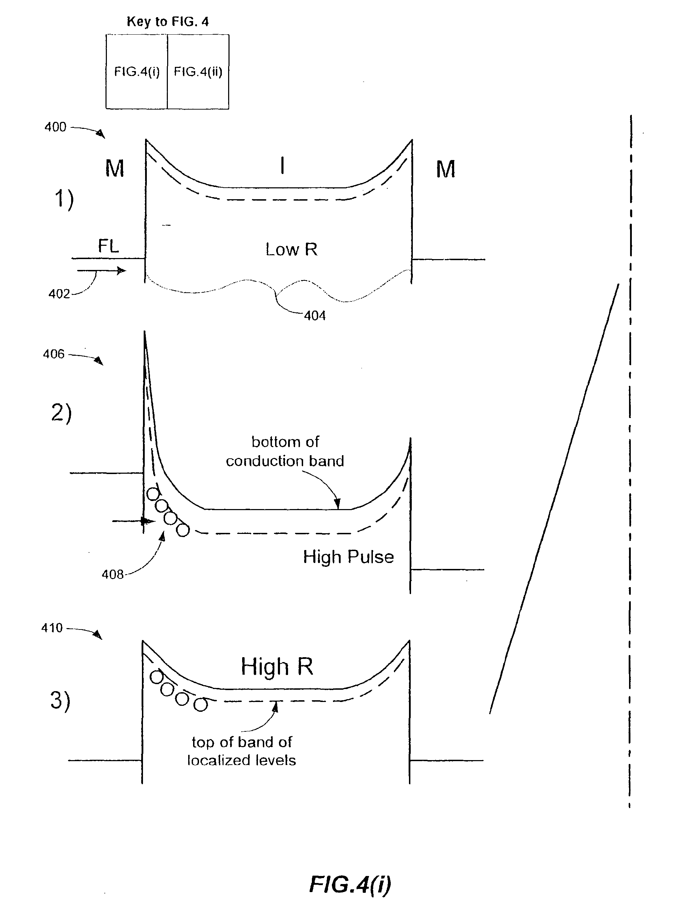

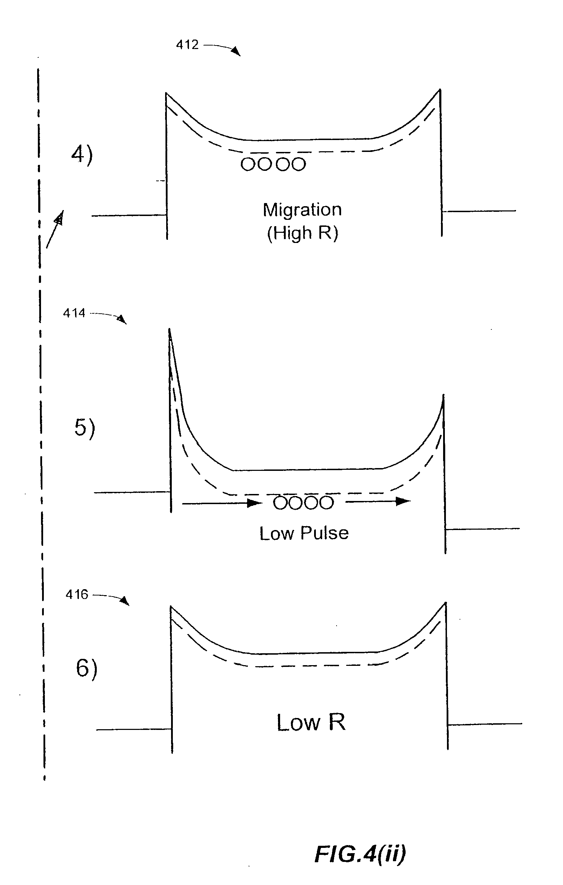

One type of memory device that is unipolar and can meet the current density and temperature compatibility requirements with poly-silicon diodes is based on a special type of dielectric film first described in the 1960's and may be similar to the operation of certain types of RRAMs being developed today, which will be discussed in further detail shortly, with respect to Fig. 4. For example, there are other materials, separate and apart from phase change memory, with electrically programmable resistance. Some of them are based on storing charge in a dielectric material. When a small (read) voltage is applied, current flows due to charge tunneling (hopping) conduction between domains (such as dopants, defects, nanoparticles, small polarons, etc.) near the Fermi level. When a larger (write) voltage is applied, charge may be trapped in a high energy configuration due to the presence of defects such as dangling bonds. When a small (read) voltage is reapplied the Coulomb field of the trapped charge modulates the current that flows (for example by changing the barrier at the electrode-dielectric interface). Therefore, the material has an electrically programmable resistance. For such a material to be used for unipolar RRAM, it must be possible to apply an appropriate voltage pulse (amplitude and duration) with the same polarity such that the stored charge is removed and the resistance is returned to the original value.

As in PCRAM, intermediate resistance values can be obtained depending on the amount of stored charge. By controlling the resistance value to fall in one of four ranges, two bits of information can be stored in a single cell. For further information regarding these devices, the reader is referred to the following references: "New Conduction and Reversible Memory Phenomena in Thin Insulating Films" J. G. Simmons and R. R. Verderber, Proc. Roy. Soc. A, vol. 301, pp. 77-102 (1967); "Novell Colossal Magnetoresistive Thin Film Nonvolatile Resistance Random Access Memory (RRAM)", W. W. Zhuang et al., International Electron Devices Meeting (IEEE), pp. 7.5.1-4 (2002); "Electrical Current Distribution Across a Metal-Insulator-Metal Structure During Bistable Switching", C. Rossel et al., Journal of Applied Physics, vol. 90, pp. 2892-2898 (2001); "Field-Induced Resistive Switching in Metal-Oxide Interfaces", S. Tsui et al., Applied Physics Letters, vol. 85, pp. 317-319 (2004); and "Ultra Low-Cost Solid-State Memory", B. Stipe, US Patent Publication No. 2004/0245547 A1.

Flash memory, based on storing charge on the floating gate of a transistor, has very serious scaling challenges because the dielectric around the floating gate must be at least 8 nanometers (nm) thick to retain charge for ten years. This can make it difficult for the floating gate to properly modulate the transistor's channel conduction. Also, the voltage used for programming flash memories must be greater than about 8 volts, making it difficult to scale the peripheral transistors that are used to supply the programming voltage. NAND flash memory is projected to have very serious scaling challenges below 40 nm due to interference between adjacent gates, particularly for multi-bit storage. Because of these limitations, there is a strong need to find a rewritable memory more scalable than flash memory.

Flash memory includes transistors that are built on the wafer resulting in one layer of memory. But to lower costs, more than one layer of memory can be stacked on top of each other creating a three-dimensional memory structure, such as the foregoing one-time programmable antifuse memory. In this manner, the number of processing steps is reduced per layer of memory, i.e. three additional mask steps per layer of memory may be required, whereas, in conventional memory processing, such as flash, 20-30 mask layers may be required to create the one memory layer and the interconnects. However, three-dimensional vertically stacked memories based on antifuses have limited application because they cannot be rewritten. Also, only one-bit-per cell can be stored because the antifuse, included in the memory structure, is either blown or not-blown thereby allowing only one bit of storage capacity per cell.

The idea behind the stacked 3-dimensional memory structure is to place all of the complex circuitry at the bottom and the simple memory layers, which are made merely of a memory element between crossed wires, on top of the complex bottom circuitry. An example of such a structure is now presented for discussion.

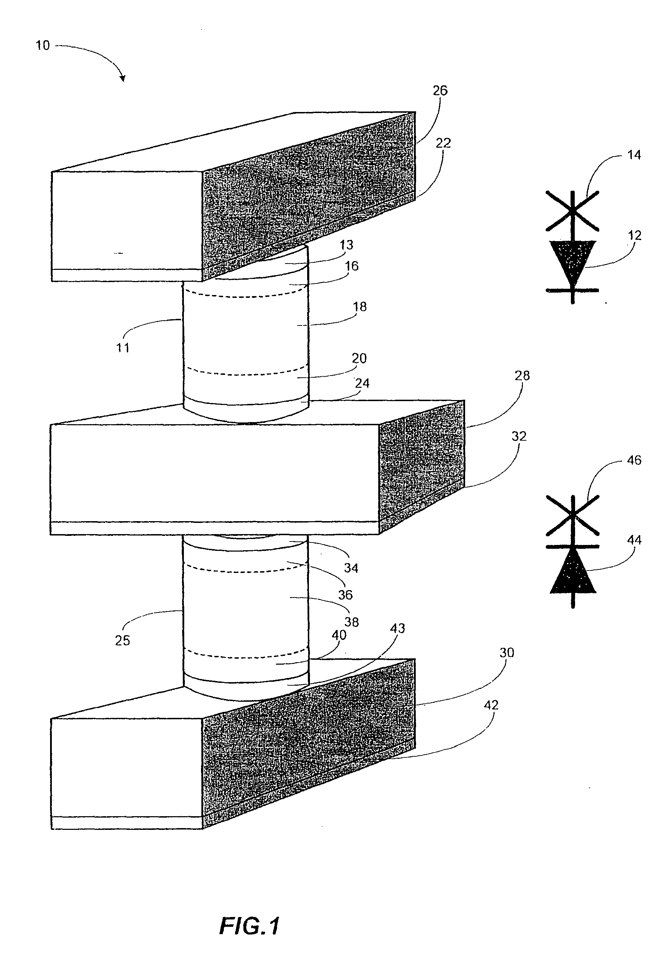

Fig. 1 shows a prior art three-dimensional memory cell structure 10 to include a pillar 11 made of a diode 12 and an antifuse 14 and a pillar 25 made of a diode 44 and an antifuse 46. The antifuse 14 and the antifuse 46 are effectively each made of a SiO₂ layer 13 and 34, respectively, formed thermally on top of the pillars 11 and 25, respectively, the details of which will be explained shortly.

On top of a TiN layer 42 is formed the bit line 30 and on top of the bit line 30, a barrier layer 43, made of, for example, TiN, is formed. Above the barrier layer 43 is formed a p+ 40, an i 38 and a n+ 36, which are shown to form a n+-i-p+ diode 44 and the SiO₂ layer 34 forms the antifuse 46 and is shown formed above the n+ 36. A TiN layer 32 is shown formed above the SiO₂ layer 34. A word line 28 is shown formed above the TiN layer 32 and on top of the layer 32, a diode 12 and an antifuse 14 structure is formed as follows. The diode 12 is made of p+-i-n+ doping, shown as p+ 16, i 18 and n+ 20 and the latter is shown formed on top of a TiN layer 24. A SiO₂ layer 13 is shown formed on top of the p+ 16 and a TiN layer 22 is shown formed on top of the layer SiO₂ layer 13. A bit line 26 is shown formed above the TiN layer 22. The structure and layers shown between the bit line 26 and the word line 28 are repeated between the word line 28 and the bit line 30 as described above.

The TiN layer 22 serves as an adhesion layer between the SiO₂ layer 13 and the bit line 26, similarly, the TiN layer 32 serves as an adhesion layer between the SiO₂ layer 34 and the word line 28 and so on.

The SiO₂ layers 13 and 34, having been thermally oxidized silicon, act as antifuses because when high voltage is applied thereto, the antifuse is blown by creating a short circuit through the SiO₂. Normally and prior to blowing or shorting, the SiO₂ is in a high resistive state. Blowing the SiO₂, or not, results in a logical '1' or '0' state. Once the SiO₂ layer 13 is blown, a short circuit is created between the bit line 26 and the diode 12. Similarly, once the SiO₂ layer 34 is blown, the diode 44 is essentially shorted with the word line 28.

As shown in Fig. 1, the bit lines and word lines are alternated so that, for example, the word line 28 appears between the bit lines 26 and 30. Furthermore, the diodes 44 and 12 are formed in opposite direction relative to each other, that is, the diode 44 is facing upwardly while the diode 42 is facing downwardly allowing bit lines and word lines to be shared between two different memory cells thereby reducing the number of mask steps and reducing costs. It should be noted that while not shown in Fig. 1, the structure 10 is repeated to form many layers extending the pillar 11 and the bit line - word line - bit line arrangement of the structure 10. Typically, in light of cost and yield issues, four or eight layers are made per memory chip. If each layer is to consume three masks (including vias), there are 24 masks required for eight layers. This is similar to the number of masks required to make the control circuits. Beyond about eight or sixteen layers, the total processing cost per layer of memory no longer drops significantly.

Briefly, manufacturing steps for forming the structure 10 will now be discussed. The steps described apply to forming the part of the structure 10 that is between the bit line 26 and the word line 28 as well as the part of the structure 10 that is between the bit line 30 and the word line 28. A layer of TiN and a layer of metal such as tungsten is placed and patterned to form a number of wires, which become the bit lines or word lines and thereon SiO₂ is deposited. Next, a chemical mechanical polishing (CMP) process is performed to planarize the surface so that the space between the wires is filled with SiO₂. Subsequently, other material is deposited to make the pillar 25, such as TiN, used as a barrier layer so that the metal wire (bit line) 30 does not mix (form a silicide) with the subsequent silicon layer (p+) 40.

Next, p-doped silicon (p+) is deposited and an intrinsic layer (i) is deposited and finally, n-type dopants are implanted forming a p-i-n diode. Next, back fill is performed with SiO₂ along with another step of CMP, thus, forming a number of pillars embedded in SiO₂ , the top of which is exposed silicon. Next, the part of the silicon layer that is exposed is thermally oxidized forming the SiO₂ antifuse 46. Typically, the silicon diodes are crystallized with a high temperature anneal after all memory layers are fabricated. The crossed nature of the bit lines and word lines are referred to as cross-point arrays.

The problem with the structure 10, of Fig. 1, is that it is not rewritable due, in large part, to the use of the antifuse 14 or 46, which allows only a one-time programmability operation. Furthermore, only one bit per cell can be stored in the structure 10 of Fig. 1.

What is needed is a rewritable variable-resistance memory device that can take the place of the anti-fuse and is compatible with a polycrystalline silicon diode. What is further needed is a unipolar device which can be written and erased using the same direction of current flow and capable of withstanding the high temperatures used during silicon crystallization of about 750 C. The required current density during operation should not exceed the current carrying capability of poly-silicon diodes. A low-cost unipolar rewritable variable-resistance memory device, made of cross-point arrays of memory cells, vertically stacked on top of one another and compatible with a polycrystalline silicon diode having current density on the order of 10² to 10⁵ A/cm² and a resistance of about 10⁴ ohm to 10⁷ ohm is needed. What is still further needed is a structure and method of manufacturing a low cost memory, such as a unipolar rewritable variable-resistance memory device, made of cross-point arrays of memory cells, vertically stacked on top of one another and compatible with a polycrystalline silicon diode.

The present invention provides a low-cost, high-performance, rewritable nonvolatile (or solid state) memory having a three-dimensional structure.
One embodiment of the present invention includes a low-cost unipolar rewritable variable-resistance memory device, made of cross-point arrays of memory cells, vertically stacked on top of one another and compatible with a polycrystalline silicon diode.

In one embodiment of the present invention, a memory structure 100 includes a pillar including a diode 118, which is, in turn, formed above a MIM RRAM stack 120, which resides above a bit line 122. The diode 118 is formed below a word line 112. Optionally a barrier layer may be formed between the RRAM stack 120 and diode 118. The intersection of the bit lines and word lines of a memory made of the memory structure 100 form layers of memory cells forming a three-dimensional memory array having millions of memory cells with a large number of memory cells placed onto a chip or integrated circuit.

Another embodiment of the present invention includes a 3-dimensional memory arrangement on top of semiconductor control circuitry. The arrangement is made of memory trees, each memory tree having one tree "trunk", which is a vertically connected metal pillar, and horizontal "branches" (or word lines) in a plurality of layers. The word lines, in a tree, share a common vertical connection to the control circuitry. The word lines may extend on either side of the vertical connection. Memory trees are arranged in a plurality of rows. Two types of memory trees alternate in the direction of the rows of memory trees so that their respective vertical connections may be spaced a convenient distance from one another. A plurality of bit lines are formed perpendicular to the word lines in at least one layer, each having an independent vertical connection to the control circuitry at the ends of the tree rows. Between the intersections of word lines and bit lines are memory pillars consisting of a series connected diode structure and unipolar RRAM memory structure. These memory pillars are in a plurality of layers. In this way, word lines and bit lines are connected through the memory pillars. Each word line may be connected to one or two layers of bit lines. Each bit line may be connected to one or two word lines of each tree in a row of trees. Each bit line is shared by trees of both types.

IN THE DRAWINGS:
Fig. 1 shows a prior art three-dimensional memory cell structure 10.
Fig. 2 shows a memory structure 100 in accordance with an embodiment of the present invention.
Fig. 3 shows a memory structure 300 in accordance with another exemplary embodiment of the present invention.
Fig. 4 shows an energy diagram for each of the MIM RRAM stacks 110 and 120 of Fig. 2.
Fig. 5 shows a cross-sectional view of an exemplary arrangement of a 3-dimensional memory arrangement 500.
Fig. 6 shows a top view of the bit lines 504 including the points of vertical connection 600 at the ends of the tree rows.
Fig. 7 shows a side view of the bit lines 504 of Fig. 6.
Figs. 8-10 show different arrangements of trees of the memory cells 498.
Fig. 11 shows a general layout of a memory array 1100.

As known in the art, large cross-point arrays of memory cells may be formed and stacked vertically on top of one another. For example, the arrays may be formed by 8192 word lines in layer 1, 128 perpendicular bit lines in layer 2, 8192 word lines in layer 3, 128 bit lines in layer 4, and on up to 8192 word lines in layer 9. Memory cells are formed at the intersections of bit lines and word lines to form 8 layers of memory cells. Thus, the 3-dimentional array includes eight million memory cells and a large number of arrays may be included on a semiconductor die.

Within each memory cell is a RRAM device, as previously described, and a poly-silicon diode. Diodes point in opposite directions in vertically adjacent memory layers so that current may flow from each bit line to any of the 16384 word lines directly above or below the bit line. Accordingly, bit lines and word lines are "shared" (expect for the bottom-most word line and top-most word line which are typically connected external to the array for symmetry of the control circuits), as will be apparent shortly relative to various embodiments of the present invention. Because the diodes limit current flow to only one direction, it is possible to confine current flow to only one memory cell in the 3-dimensional array or, if desired, simultaneously to multiple memory cells by controlling the voltages on each of the bit lines and word lines. Various embodiments of memory arrangements will now be discussed with reference to figures.

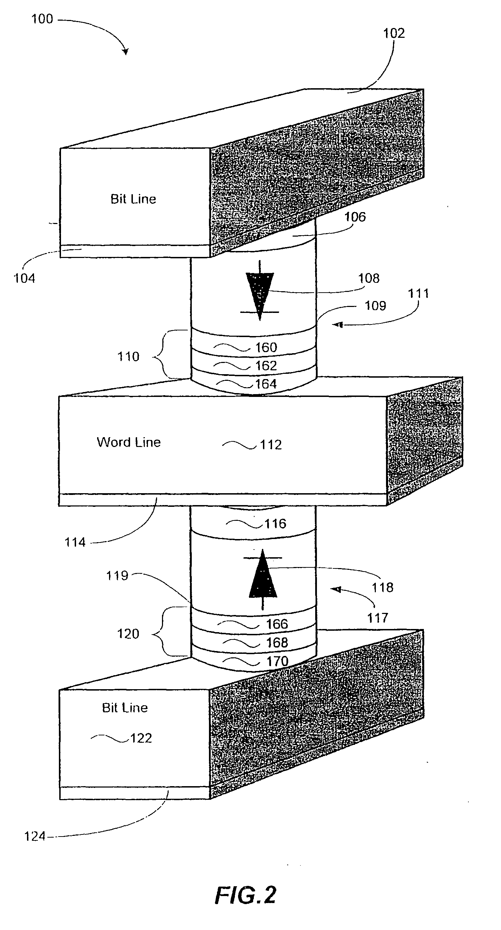

Referring now to Fig. 2, a memory structure 100 is shown in accordance with an embodiment of the present invention. The memory structure 100 is shown to include a bit line 102 formed on top of an adhesion layer 104, an example of which is TiN, which is, in turn, formed on top of a contact layer 106. A diode 108 is formed below the contact layer 106 and below the diode 108, a unipolar re-writable RRAM stack 110, an example of which is a metal-insulator-metal (MIM) RRAM stack, is formed, below which, a word line 112 is formed. The MIM RRAM stack 110, the diode 108 and the contact layer 106 form a pillar 111. Optionally a barrier layer 109, such as TiN, may be formed between the RRAM stack 110 and diode 108 so as to prevent contact with silicon.

The structure 100 includes a pillar 117, vertically stacked below the pillar 111 and formed of a contact layer 116, which is formed above a diode 118, which is, in turn, formed above a MIM RRAM stack 120, which resides above the bit line 122. Optionally, an adhesion layer 124 is formed below the bit line 122. In fact, the contact layer 116 and the contact layer 106 are also optional. In the absence of the layer 116, the diode 118 is formed directly below the word line 112, otherwise, the contact layer 116 is formed directly below the word line 112. Optionally a barrier layer 119, such as TiN, may be formed between the RRAM stack 120 and diode 118. The bit lines 102 and 122 and the word line 112 are made of metallic material and the intersection of the bit lines and word lines of a memory made of the structure 100 form layers of memory cells forming a three-dimensional memory array having millions of memory cells with a large number of memory cells placed onto a chip or integrated circuit.

In one embodiment, each of the diodes 108 and 118 is composed of poly-crystalline silicon.

The stack 110, in Fig. 2, is shown to include a metal (M) layer 160 below which is formed an insulator(I) layer 162 below which is formed a metal(M) layer 164, thus, forming a MIM stack. Similarly, the stack 120 is shown to include a metal (M) layer 166 below which is formed an insulator(I) layer 168 below which is formed a metal(M) layer 170, thus, forming a MIM stack. It should be understood that while only two pillars are shown in Fig. 2, many more may be employed in a vertically-stacked formation, such as shown with respect to the pillars 111 and 117. In one embodiment of the present invention, the insulator layer in each of the MIM stacks 110 and 120, for example, the layer 162 or the layer 168, is made of distinct insulating layers. That is, it may be formed of two, three or more layers of the same or different types of insulation material. The layers may be of the same basic material distinguished by having different atomic compositions. Additionally, in another embodiment of the present invention, the metal in each of the MIM stacks may be of a different composition. For example, the M layer 160 may be made of a different type of metal than that of the M layer 164, similarly, the M layer 166 may be made of a different type of metal than the M layer 170. In yet another embodiment, both metal types may be the same. The metal layers in each of the MIM stacks are made of Pt, Ir, Pd, Ru, or Rh but other metal material may be employed to form the same.

The diodes 108 and 118 are made of poly-silicon and they point in opposite directions relative to each other in vertically adjacent memory layers, so that current may flow from each bit line to either of the word lines directly above or below the bit line. Thus, the bit lines and the word lines are "shared"(except for the bottom-most word line and top-most word line which are typically connected externally to the array for symmetry of the control circuits, which reside at the bottom-most layer of a memory chip). Because the diodes 108 and 118 limit current flow to only one direction, it is possible to confine current flow to only one memory cell in the three-dimensional memory array or, if desired, simultaneously to multiple memory cells by controlling the voltages on each of the bit lines and word lines.

The layers 104, 114 and 124 act as adhesion layers so that the wires adhere to the SiO₂ dielectric. The layers 106 and 116 act as contact layers, protecting the silicon during CMP and further act as CMP hard stop layers such that during a CMP process, polishing automatically stops at the these layers due to their hard characteristic. Other substitutes for TiN in the layers 106 and 116 include but are not limited to TaN and TiAlN.

In comparison to the prior art structure 10 of Fig. 1, the structure 100 of Fig. 2, in accordance with an embodiment of the present invention, replaces the anti-fuses 14 and 46 with rewritable devices, i.e. RRAM structures. The latter is compatible with the manufacturing steps used to manufacture memory stacks thereby withstanding high temperatures and being unipolar, i.e. writing '1' or '0' using one direction current flow, and requiring reasonable current levels because poly-silicon diodes are not able to supply very high current.

The diodes 108 and 118 which are poly-silicon diodes, may be p-i-n diodes and formed as described previously. To form the diode 108, n-doped amorphous silicon is deposited, followed by intrinsic silicon. An implantation is performed to make the p-type layer. The bottom layer is doped in-situ, i.e. it is deposited in this manner. The top layer, which is p-doped, is implanted. In the previously formed lower memory layer, the foregoing steps were reversed to create the diode 118 pointing in the opposite direction to that of the diode 108. To create the diode 118, the p-type layer is first placed, which is doped in-situ and then pure silicon is placed and then n-dopants are implanted, creating a p-i-n diode 118 that is oriented in the opposite direction as that of the diode 108. That is, diodes point in opposite directions in vertically adjacent memory layers. The reason for the opposite direction is so that current flows to each word line from any of the bit lines directly above or below the word line, thus, "sharing" the word lines except for the bottom-most word line, as previously stated. In the manner described herein, all of the layers of memory are built.

Upon completion of building all of the layers of memory, the layers are heated to a high temperature, enough to crystallize all of the diodes, such as the diodes 108 and 118 and this process converts the diodes, which are in amorphous state into poly-silicon diodes. That is, the high temperature crystallizes all of the diodes at approximately 750 degrees C. To convert the amorphous state of the diodes to poly-silicon diodes, a high temperature anneal process is employed.

To recap the formation of a pillar, such as the pillars 110 or 120 of Fig. 2, a SiO₂ dielectric is deposited and planarized to isolate the control circuits from the memory array. An optional adhesion layer (such as TiN) and an interconnect layer (such as Tungsten) are deposited and etched to form the first layer of word lines. SiO₂ is deposited and CMP is again used to planarize. Then the MIM RRAM stack memory layers are deposited and Si diode layers are deposited, as discussed in further detail above.

A barrier material (or layer), such as TiN or TiAlN, may be optionally used to prevent mixing of the memory electrode and the bottom Si (silicon) diode layer. The diodes may be p/n, p-i-n, or a metal may be used to form a Schottky diode. Typically, the diode is p-i-n with the lower layer doped in-situ and the upper layer doped by implantation. The deposited silicon may be amorphous or may be partially crystallized during deposition (full crystallization and dopant activation may be accomplished by a thermal anneal after the 3-D array is formed).

At this point, an optional hard ohmic contact layer (such as TiN) may be deposited on the silicon and the entire stack is etched down through the MIM RRAM layers to form pillars. Si02 is deposited and CMP is used to planarize the surface thereof. The hard ohmic contact layer provides a CMP stop and protects the silicon during CMP. In another variation, a softer metal contact layer may be used and a sacrificial hard mask material (such as DLC carbon) used on top. The sacrificial layer is later removed after CMP (for example by using an oxygen-based etch). At this point, after the next layer of wires are formed, the entire process is repeated except the direction of the diode is reversed. If two different metals are used in the MIM RRAM stack structure, i.e. the metal layer 160 being different than that of 164 or the metal layer 166 being different than that of 170, the order of these metals is also reversed to maintain the same device polarity.

The MIM RRAM stacks 110 and 120 replace the anti-fuses 14 and 46 of Fig. 1, respectively. In this manner, the structure 100 becomes re-writable. That is, with respect to each pillar, such as the pillar 110, charge is reversibly trapped in the insulator layer 162.

A barrier layer 119 may be optionally formed between the top metal layer 166 of the MIM RRAM stack 120 and the diode 118. The use of the foregoing barrier layer option is based, in large part, on the type of metal used in the MIM stack, that is, if a metal is used that does not readily diffuse into silicon, no barrier layer is likely to be required.

Also, alternatively, the MIM RRAM stack 110 can be placed after or on top of the diode 108 rather than placed on top of the word line 112. Similarly, the MIM RRAM stack 120 can be placed on top of the diode 118, rather than on top of the bit line 122. An advantage of placing the MIM RRAM stacks 110 and 120 on top of the bit or word lines is that the surface of the bit or word line is polished flat due to CMP, whereas, the poly-silicon may be rough due to crystallization of the silicon.

The insulator layers 162 and 168 may be formed of various insulating material including but not limited to doped Si₃N₄, doped SiO₂, NiO, ZrO₂, HfO₂, TiO₂, Cu₂O, or PCMO.

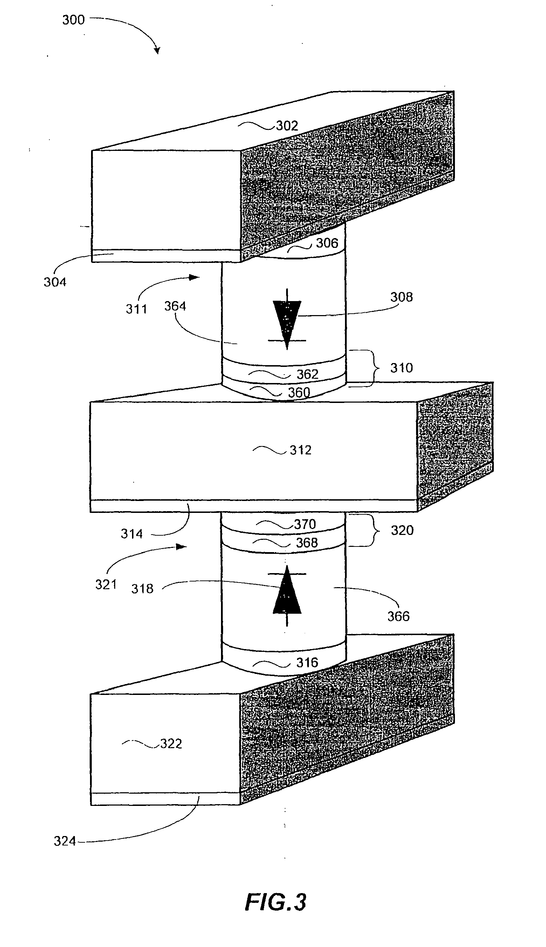

The MIM RRAM stacks 110 and 120 are unipolar and form a memory array based on the structure 100 and they require as few as a couple of masks per layer to manufacture. Thus, manufacturing costs are effectively reduced over that of conventional memory, such as flash. Typically, processing is proportionate to the number of mask steps and represents about 60% of the total costs of manufacturing memory. Thus, doubling the number of processing steps increases costs by about 60%. While, in the embodiments of Figs. 2 and 3, the total number of masks is doubled, eight layers of memory is obtained when eight pillar stacks are employed, thus, effectively increasing memory 8 times over conventional techniques. Additionally, in conventional memories, the bottom layer of transistors, i.e. the control circuitry, need be placed on the periphery of array of memory devices. However, with three-dimensional memory, such as memory made of the structure 100, the control circuitry may be located underneath the memory array thereby saving half of the silicon real estate and further reducing manufacturing costs.

Fig. 3 shows another exemplary embodiment of the present invention wherein a memory structure 300 is shown to include an adhesion layer 324 on top of which is shown formed a bit line 322. A barrier layer 316 is shown placed on top of the bit line 322 and on top of the latter, a diode 318 is shown formed, on top of which a MIS RRAM stack 320 is formed, made of a semiconductor layer 366, which is the same as the diode 318. An insulator layer 368 is shown formed on top of the diode 318 and on top of the insulator layer 368 is shown formed a metal layer 370.

A TiN layer 314 is shown formed on top of the metal layer 370, or stack 320, and on top of the layer 314, there is formed a word line 312 on top of which is shown formed a unipolar re-writable RRAM stack 310, an example of which is metal-insulator-semiconductor (MIS). The stack 310 is shown made of a metal layer 360, an insulation layer 362 and a semiconductor layer 364, the latter being the diode 308, similar to the make up of the pillar 321. The metal layer 360 is formed on top of the word line 312 and on top thereof, the insulator layer 362 is shown formed. The diode 308 is shown formed on top of the stack 310 and on top of the diode 308, contact layer 306 is shown formed. A TiN layer 304 is shown formed on top of the contact layer 306 and on top of the latter, a bit line 302 is shown formed.

It should be noted that the layers 324, 314, 304, 306 and 316 are optional. The MIS RRAM stacks 310 and 320 are unipolar. The contact layer 316, the diode 318 and the MIS RRAM stack 320 form a pillar 321.

In Fig. 3, the MIM structure of the stacks 110 and 120 of Fig. 2 is replaced with an MIS structure and the same current flow direction as that of Fig. 2 is maintained. The MIS structure of Fig. 3 lacks one of the metal layers of the MIM structure of Fig. 2. Since the diodes of Fig. 3 are pointing in the same direction as that of Fig. 2 and current flows in only one direction, namely from the bit line 302 toward the word line 312. The placement of the MIS RRAM stack relative to the diode of the same pillar assumes trapping negative charge at the metal-insulator interface. Stated differently, since the diode 308 points down, electron flow is from the metal layer 360 into the insulator layer (or dielectric) 362 and trapped charge occurs at the metal-insulator interface, such as is done by the MIM structure of Fig. 2.

In Fig. 3, since the diode 318 points up, electron flow is from the metal (the metal layer 370) into the dielectric (the insulation layer 368) and trapped charge would occur at the metal-insulator interface as for the MIM memory structure. In order to maintain symmetry for the upper pillar stack (or the stack 310), the MIS memory structure (or the stack 320) is on top of the diode 318 so that trapped charge is still at the metal-insulator interface. Also, on top of the contact layer 306, a sacrificial hard mask (not shown), such as DLC, may be used as a CMP stop layer.

Fig. 4 shows an energy diagram for each of the MIM RRAM stacks 110 and 120 of Fig. 2. At 400, the energy diagram, in the absence of a pulse, is shown with the direction of carrier flow being indicated by 402. The vertical axis indicates energy. The insulator layer 404 at this point has low resistance. At 406, which occurs during programming or write operation, high voltage pulse is applied and charge is trapped at 408 or near the metal-insulator interface discussed earlier near the top of the band of localized levels. Next, at 410, the insulator layer exhibits high resistance while trapped charges remain but at the top of the band of localized levels. The difference between the high resistance and low resistance at 410 and 400 is approximately 100 times or more. As shown at 412, charges quickly migrate (diffuse) away from the interface to states of somewhat lower energy near the center of the dielectric. Next, at 414, when a low voltage pulse is applied, the trapped charge is swept out of the insulator layer and at 416, the insulator layer, once again, enters a low resistance state. The direction of current flow remains the same throughout the states shown in Fig. 4, thus, a diode may be used to write to and erase memory using the same direction of current flow.

As shown in the carrier energy diagram of Fig. 4, the cell structure includes a dielectric layer or dielectric multilayer in a metal-insulator-metal (MIM) or metal-insulator-semiconductor (MIS) configuration. Application of low voltage across the device leads to a read-back current caused by charge tunneling (hopping) conduction between domains in the dielectric near the Fermi level. These domains are typically separated by 2 or 3 nanometers and may be dopants, nanoparticles, or defects, or in some materials they may be thermally-generated small polarons as in the CMR materials. Application of a short large voltage pulse (about 5 V) traps charge in the dielectric in a high energy configuration near one interface such that the read-back current is significantly reduced and the device is in a high resistance state. These traps are typically defects in the dielectric or dielectric multilayer such as dangling bonds.

Typically, the high resistance is caused by a change in the electric field at the interface caused by the trapped charge. This trapped charge, which causes modulation of the resistance, may stay near the interface or may migrate toward the center of the dielectric by diffusion to nearby sites of similar energy. This trapped charge is unlikely to tunnel to the localized lower energy states that contribute to the readback current because of the large energy difference or possibly because of stabilizing electron-electron interactions. Thus, the memory is non-volatile. Application of the medium voltage pulse (about 3 V) or a longer large voltage pulse removes the trapped charge and returns the device to the low resistance state. By carefully timing the pulse length and amplitude, only some of the trapped charge may be removed and stable intermediate resistance states may be reached. Control circuitry can monitor the resistance until a desired resistance is reached. By binning the resistance into four ranges, two bits of information may be stored per memory cell.

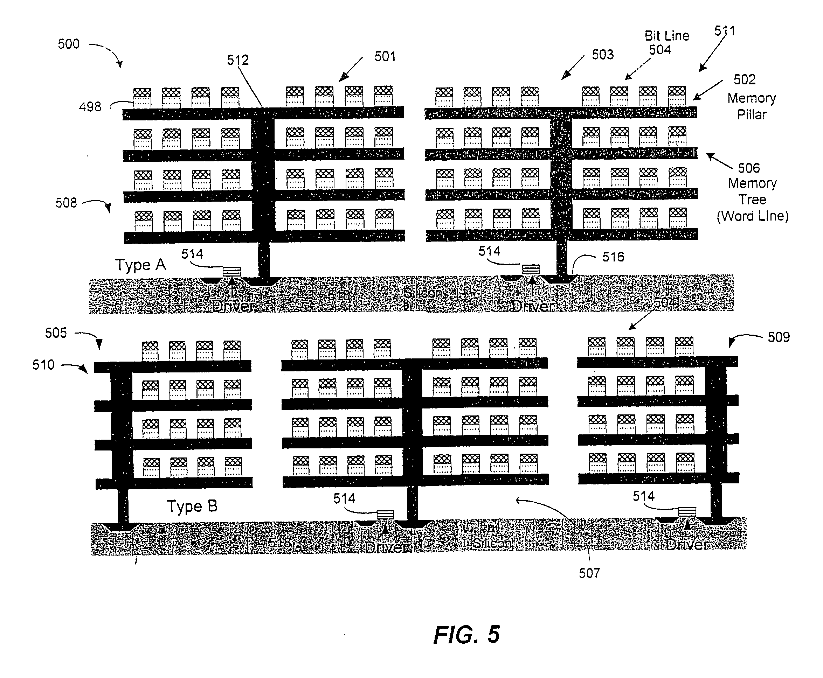

Next, different ways in which pillars are wired to the silicon control circuitry will be shown and discussed relative to Figs. 5-10. It should be noted that Figs. 5-10 show examples of such wiring schemes and other wiring schemes may be readily employed without departing from the scope and spirit of the present invention.

In accordance with the present invention, a cross-sectional view of an exemplary arrangement of a 3-dimensional memory 500 is shown in Fig. 5, which is shown to have tree-like arrangement of the word lines and memory pillars in accordance with an embodiment of the present invention. The 3-dimensional memory arrangement500 includes a plurality of memory cells (or memory pillars) 498,each of which is a pillar, similar to that of the pillars 111 and117 of Figs. 2 and 3. An array of pillars 502 is shown formed below bit lines 504. The memory cells 498 are arranged in a tree-like structure, referred to herein as a "memory tree". While not shown in Figs. 5, 8, 9 and 10 in this manner due to the planar view shown therein, the memory trees are arranged in a row extending out of the page. In the case where two different types of memory trees are employed, the first type is in a first position in the row and a second type in is a second position in the row and in the third position is another one of the first type and so on with the row of memory trees extending out of the page. In one embodiment of the present invention, the same type of memory tree is used throughout the tree-like memory arrangement. Not all memory cells 498 are indicated for simplification of Fig. 5.

Tree-like memory arrangements have a number of advantages, among which are, more than one layer of memory (tree branches) are connected together to a common vertical interconnect (tree trunk). In doing so, the support circuitry is greatly simplified, the number of vertical interconnects is minimized, and the disturbance between cells is minimized. Tree-like memory arrangements were originally discussed for memory cells that do not include a diode (such as FRAM or bipolar RRAM) where cross-talk and disturbance is an especially important problem. The tree structures of the various embodiments of the present invention however, are optimized for unipolar RRAM with a diode in the memory pillar. For earlier discussion of a tree-like arrangement, the reader is referred to U.S. Patent Publication No. US2004/0245547A1, entitled "Ultra Low-Cost Solid-State Memory" by B. Stipe, the contents of which are incorporated by reference as though set forth in full.

Five memory trees, 501, 503, 505, 507 and 509, are shown to form a tree arrangement 511 included in the memory arrangement 500. The word lines 506 form branches of the trees. To add perspective to the memory arrangement 500, two cross sections are shown to include two types of memory trees, "type A" and "type B" with bit lines 504 coming out of the page. In this example, the type B trees are offset by half a tree distance relative to the type A trees. Type A and type B alternate in the direction of the bit lines to form rows of trees so that the same bit lines first pass through type A trees, then B, then A, etc. Each of the pillars 502 includes an MIM RRAM stack and a diode similar to that which is shown in Fig. 2 or it can be the MIS RRAM stack and a diode similar to that shown in Fig. 3. Unlike Figs. 2 and 3, however, the memory arrangement 500 has all diodes pointing in the same direction, thus, avoiding "sharing" bit lines and avoiding sharing word lines. This is because word lines and bit lines only connect to one layer of memory pillars.

Each of the tree trunks 512, which are shown to be extensions, in a perpendicular formation to the word lines, is shared by other layers of memory. However, it is important to note that only one trunk extends through each tree. Drivers 514 for each tree drive each tree through the use of a transistor. For example, the driver of the tree 503 includes a transistor 516, which is coupled to the trunk 512 of the tree 503. While only one transistor is shown to be coupled to the trunk of each tree, the rest of the select circuitry is not shown for clarity. Transistors 516 are formed on the silicon substrate. The trunks and branches are made of a conductive material, such as tungsten.

In the tree-like arrangement of Fig. 5, more than one layer of memory is shown coupled together to a common vertical interconnect, i.e. the trunk 512. Accordingly, the support circuitry is greatly simplified, the number of vertical interconnects (trunks 512) is minimized and the disturbance between cells is thus minimized. The tree structure of Fig. 5 is particularly optimized for unipolar RRAM with a diode in the memory pillar, examples of which are shown in Figs. 2 and 3.

As shown in Fig. 5, memory pillars 502 are arranged in different positions along a bit line, i.e. positions 508 and 510, on branches of word line trees with each word line branch connected to a layer of memory pillars and to one layer of bit lines in another layer. The diode in the memory pillar restricts current flow to only one direction (for example from bit line to word line) and all diodes point in the same direction in all layers, in contrast to that which is shown relative to Figs. 2 and 3, as previously noted.

As shown in Fig. 5, memory pillars are arranged in different layers on branches of a word line tree with each word line branch in a layer connected to a layer of memory pillars and to one set of bit lines in another layer. The diode in the memory pillar restricts current flow to only one direction (for example from bit line to word line) and all diodes point in the same direction in each layer. Type A and Type B trees alternate in a row of trees with bit lines threading the row. The advantage of using two types of trees in this manner is to space out the tree trunks to create more room for a driver circuitry (4F spacing rather than 2F spacing) and allow for wider tree trunks to make fabrication easier. It should be appreciated that the length of the tree branches may be increased to make room for complicated control circuitry under the trees. For example, each branch may have 10 to 100 or more memory pillars. One of the advantages of the tree structure of Fig. 5 is that diodes all point in the same direction to ease fabrication.

The tree-like structure is offset in its row position, by half of a unit or tree, relative to the trees at an adjacent position with bit lines threading the row. This offset is shown in Fig. 5 by indication of two types of trees, Type A trees, shown in position 508 and Type B trees, shown in position 510. The advantage of using two types of tree structures, in this manner, is to space out the trees to create more space for the drivers 514 and to allow fatter or wider tree trunks for ease of fabrication. In this manner, there is an A-B type tree arrangement and it goes on in this manner, as ABAB... A unit of "F" is generally used in the industry for referring to the resolution of lithography and in the structure of Fig. 5, a 4F spacing rather than the common 2F spacing is employed between tree trunks 512 of the same type of tree along a row, which eases manufacturing because a transistor is used at every 4F rather than 2F.

Only one trunk is used to supply the metal connection for every word line of a tree thereby reducing the number of mask steps and reducing manufacturing costs. Due to the tree-arrangement of Fig. 5, control circuitry may be placed under the trees. Furthermore, while only one transistor 516 is shown at the trunk 512 of each tree, there may be and normally are many more transistors. However, one selects the particular tree to which the transistor is coupled at its trunk. Moreover, the tree branches are typically very long with many memory cells included therein.

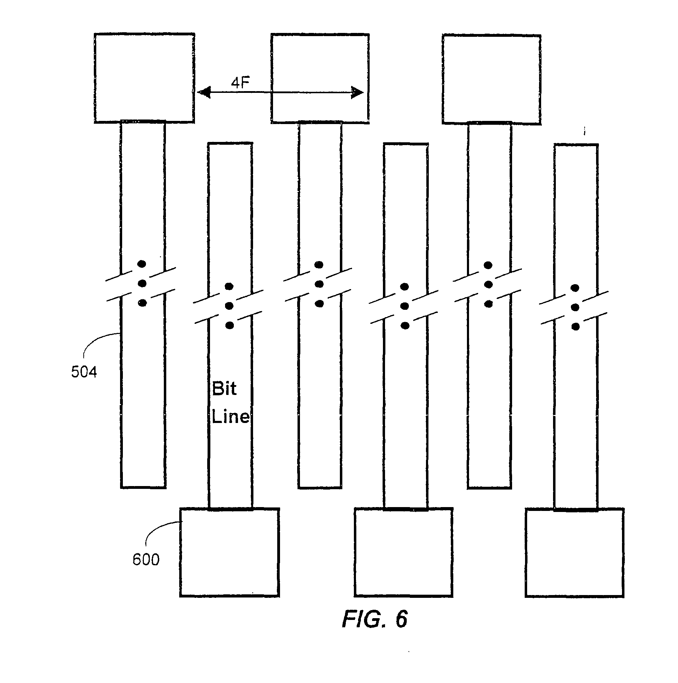

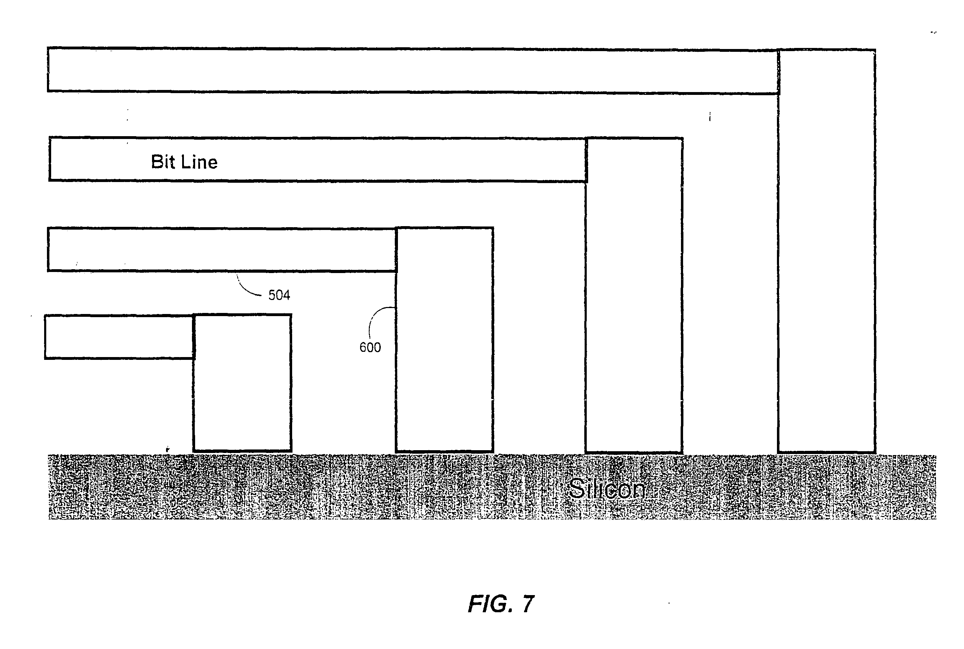

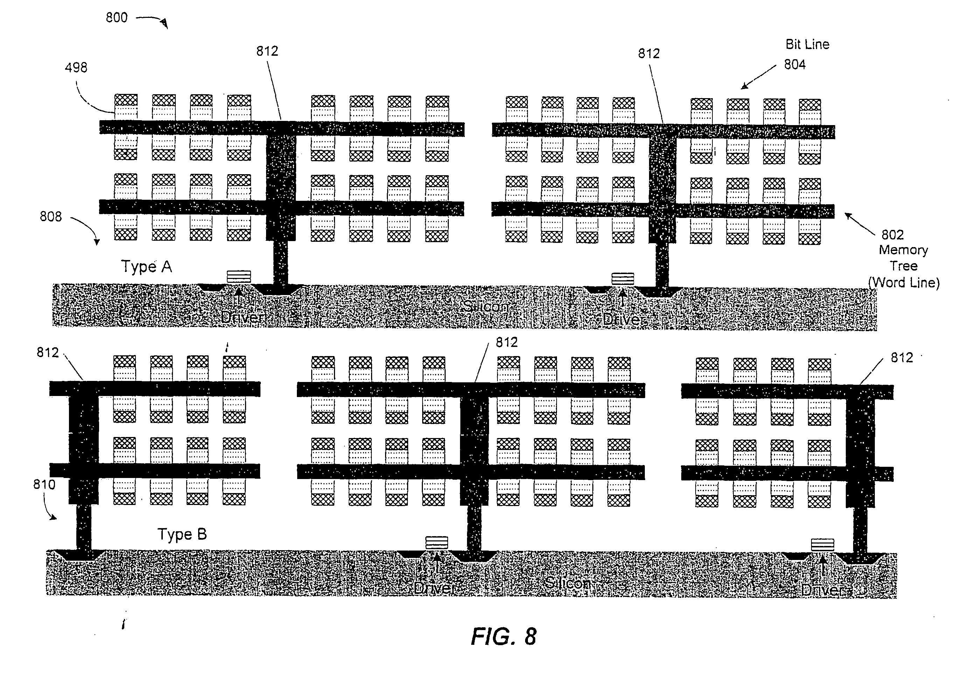

Fig. 6 shows a top view of the bit lines 504 and each include a vertical connection 600 for connecting the bit line to select circuitry and sense amp circuitry. The spacing between the bit lines 504 is 2F because each bit line is F wide and the spacing between each bit line is F. The spacing between the vertical connections is 4F, easing fabrication of the control circuits. Each select transistor at the end of the vertical connections 600 may be spaced by 4F. Each bit line has an independent connection to silicon, whereas, word lines do not each have such a connection. Fig. 7 shows a side view of the bit lines 504 of Fig. 6 including the vertical connections 600 at the end of the tree rows. For clarity, select transistors are not shown at the bottom of the vertical connections 600. Figs. 8-10 will now be discussed with reference to different arrangements of trees of the memory cells 498.

In Fig. 8, the branches of the trees are shown to include memory cells 498 above and below each branch of a tree with each memory cell 498 connecting to a bit line. Thus, each branch connects to two layers of memory pillars or memory cells. Each of the bit lines 804 connects to only one layer of word line branches 802 through one layer of memory pillars. Thus, branches are shared but bit lines are not shared, in contrast to that shown in Fig. 5. Fig. 8 shows a cross-sectional view of another exemplary arrangement of a 3-dimensional memory 800, which is similar to the memory arrangement 500 except for the differences described and shown herein.

As shown in Fig. 8, each branch in a layer may connect to two layers of memory pillars and two layers of bit lines in vertically adjacent layers. In this case, each bit line connects to only one layer of word line branches. Therefore, the branches are shared but bit lines are not shared. Diodes alternate direction in each memory layer.

The word lines 802 are shared, however, the bit lines 804 are not shared by memory pillars in different layers. Bit lines 804 are formed above and below each layer of branches, and memory cells 498 are formed above and below each branch. In this case, the diodes alternate in direction, that is, the diodes of vertically adjacent memory pillars face in opposite directions. The spacing between the trunks 812 along a row of Type A trunks or Type B trunks is 4F although other spacing may be employed. A spacing of 4F, as previously explained, eases manufacturing constraints. The trees of Fig. 8 are offset in adjacent positions in the direction of the tree rows in the same manner as that of Fig. 5. The arrangement of Fig. 8, however, over that of Fig. 5, reduces fabrication costs by requiring fewer masks because there are only half as many branches.

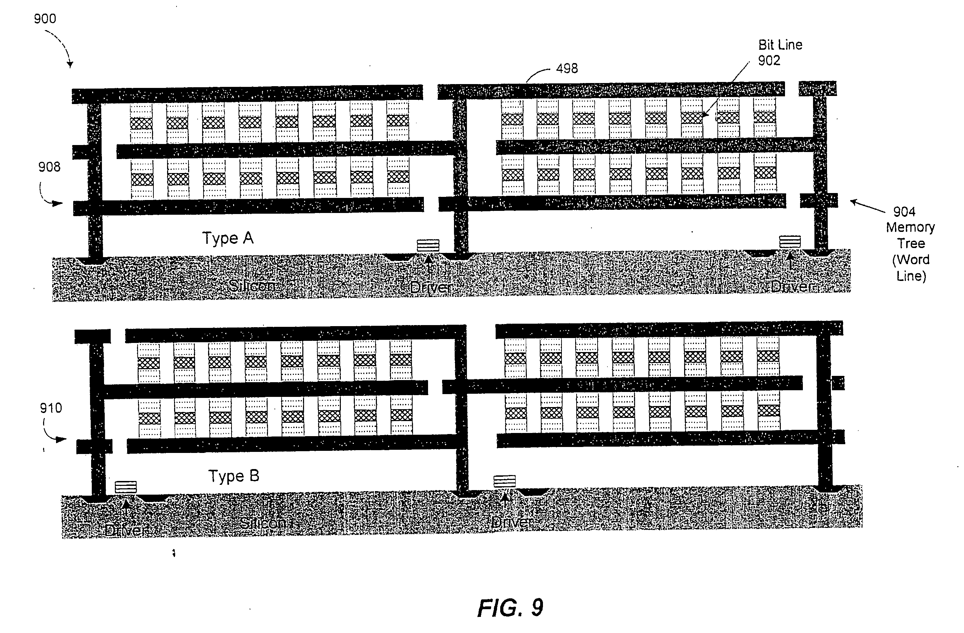

Fig. 9 shows another exemplary memory tree arrangement 900 wherein both word lines and bit lines 902 are shared by memory cells or pillars (except for top and bottom word lines as previously discussed). There are memory cells 498 above and below each of the bit lines 902 and there are memory cells 498 above and below the word lines 904. Each of the row positions 908 and 910 has two layers of bit lines 902 in contrast to Fig. 8 where 4 layers of bit lines were used for the same number of memory cells, thus, the number of bit lines is cut in half, thereby decreasing manufacturing costs. Type A trees at position 908 are mirror images of Type B trees at position 910 and these two types alternate along a row of trees. It is, however, difficult to form tree trunks because the trunks are 2F apart, rather than 4F apart. However, as bit lines and word lines are shared, the number of bit lines is cut in half and masks are saved during manufacturing. Furthermore, the number of select circuits connected to the ends of the bit lines (not shown) is reduced. The number of tree trunks remains the same as shown in Figs. 5 and 8 and the number of memory cells 498 connected to each tree remains the same as well. However, tree trunks are not offset in position. In Fig. 9, diodes alternate in each vertically adjacent layer of memory pillars and the structure thereof corresponds to that of Fig. 2. As shown in Fig. 9, some of the word lines (or branches) 904 have memory cells (or pillars) 498 formed below thereof, below which are bit lines 902. Some of the word lines 904 have memory cells 498 formed above thereof, above which are bit lines 902 and some of the word lines 904 have memory cells 498 formed below and above thereon. It should be noted that for the sake of simplicity, only a limited number of memory cells 498 are shown in Fig. 9, whereas, many more are formed in actuality. Furthermore, the term "branch" refers to a "word line" as used herein.

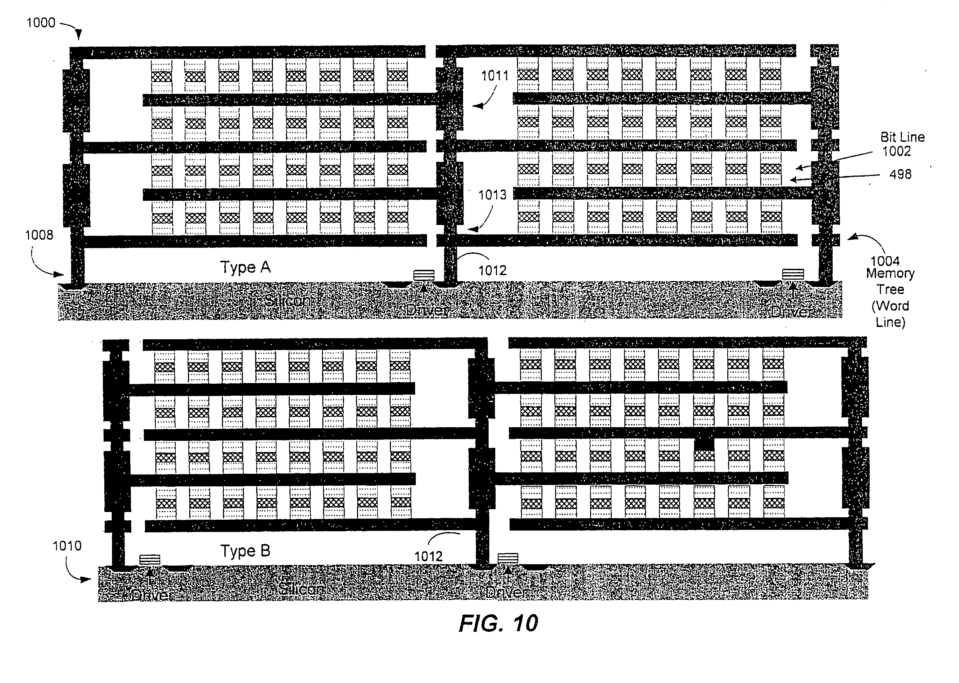

Fig. 10 shows another exemplary memory arrangement 1000 with branches (or word lines 1004) and bit lines 1002 being shared. The tree trunks 1012 are offset in position with respect to position 1008 and position 1010. Type A trees are mirror images of type B trees. The position 1008 includes type A trees and the position 1010 includes type B trees, which allows for a 4F spacing between the trunk 1012 of type A trees and the next Type A tree in a row. Due to offset, the nearest type B trunk can be 4F or more away as well. Also, major sections of the trunks 1012 are fat or wide, such as noted at sections 1011. To ease fabrication however, some sections 1013 of each of the trunks 1012 must be the same size as the memory cells 498 so that those sections can fit between branches spaced by 2F along the row. Those skilled in the art will appreciate that sections of the trunks may be formed at the same time as sections of the vertical connections 600 at the end of the bit lines to save mask steps.

A comparison of Fig. 10 with Fig. 5 reveals that the number of bit lines and tree trunks is the same, the number of tree branches is only increased by one, and the number of memory cell layers is increased from four to eight. Thus, only approximately, five additional mask steps are required to form the tree structure shown in Fig. 10, as compared to Fig. 5. The memory capacity is doubled and the control circuitry complexity is similar. In Fig. 10, type A trees are a mirror image of type B trees, and the offset allows the section 1011 of the tree trunks to be wider or fatter. The tree trunks, in Fig. 10, are offset in each of the positions 1008 and 1010. In the sections 1013 where the trunks are thinner, the branches have enough space, i.e. 2F, otherwise, the trunk would hit the branches in adjacent trees. The offset fits the thick sections of the trunks of one tree type and fits into dead space of adjacent trees of another tree type.

To select a memory cell (or memory pillar) 498 for reading or writing, a bit line and tree are selected. For example, the selected bit line is brought high, unselected bit lines are kept low, a selected tree is brought low, and unselected trees connected to the selected bit line are protected by bringing them high. For the structures shown in Figs. 5, 8, 9 and 10, the unselected trees that must be protected are in two rows of trees. Multiple bit lines may be selected to access more than one, bit simultaneously either in the same row, adjacent rows, or across the whole tree array. Preferably, only one bit per row or row pair is selected at a time to minimize the number of sense amplifiers. Alternatively, sense amplifiers may be connected to trees instead and multiple bits in a row of trees may be accessed. That is, each row may be subdivided into blocks with circuitry that selects out one tree in a block and a row for the sense amplifier.

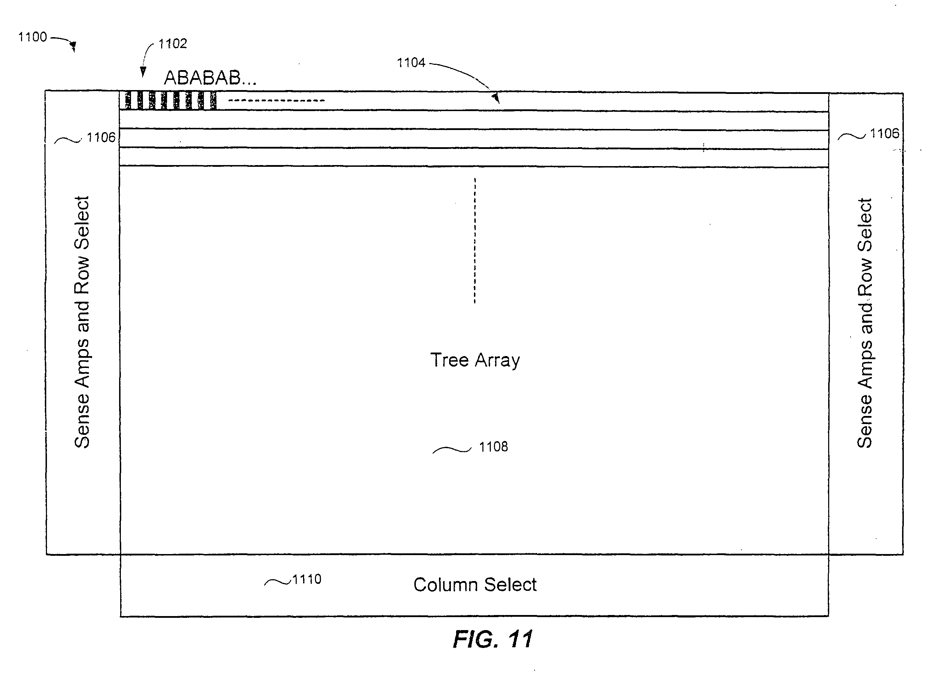

Fig. 11 shows a general layout of an integrated circuit or chip 1100 in the case where only one bit per row or row pair is selected at a time. Rows 1104 of trees form a tree array 1108 on the periphery of which is formed sense amplifiers and row select circuitry 1106 and at the bottom of which is formed column select circuitry 1110. Type A and type B trees 1102 alternate in the direction of the rows 1104 of trees. For the cases of Figs. 5 and 8, there are large offsets in the positions of the A and B types. For clarity this is not indicated in Fig. 11. There may be 1000 to 10000 trees or more in a row with the same set of bit lines threading through the entire row. At the ends of the rows, each bit line is independently connected to silicon select and sense amp circuitry. Preferably, half of the bit lines in each layer are connected at one end of the row and the other half connected at the other end of the row. This allows for a forgiving 4F spacing in the bit lines that need be connected. Each tree branch may be about 100 memory pillars in length and there may be about 100 rows of trees in an array of trees.

If there is enough space under the trees, sense amplifier circuits and select circuits 1106 can be under the array rather than on the periphery to save die area. It should be noted that the figures referred to herein are not drawn to scale.

Although the present invention has been described in terms of specific embodiments, it is anticipated that alterations and modifications thereof will no doubt become apparent to those skilled in the art. It is therefore intended that the following claims be interpreted as covering all such alterations and modification as fall within the true spirit and scope of the invention.

### Additional features of the invention are discussed in the following clauses:

1. A memory structure comprising:
   vertically-stacked first and second memory pillars separated by a bit line or word line, the first pillar including,
      a first diode having a first direction of current flow;
      a first unipolar re-writable resistance random access memory (RRAM) stack formed below the first diode and above a bit line or word line separating the first and second pillars;
   the second pillar including,
      a second diode positioned to have a second direction of current flow being opposite to the first direction of current flow; and
   a second unipolar re-writable RRAM stack formed below the second diode.
2. A memory structure, as recited in clause 1, further including a first bit line formed above the first diode and a second bit line formed at the bottom of the second pillar and below the second stack.
3. A memory structure, as recited in clause 2, further including a first contact layer formed between the first diode and the first bit line and a second contact layer formed between the word line and second diode.
4. A memory structure, as recited in clause 3, further including a first adhesion layer formed between the first bit line and the first contact layer.
5. A memory structure, as recited in clause 2, further including a second adhesion layer formed below the second bit line.
6. A memory structure, as recited in clause 1, further including a first barrier layer formed between the first stack and the first diode and a second barrier layer formed between the second stack and the second diode.
7. A memory structure, as recited in clause 1, wherein the first and second re-writable stacks are each made of metal-insulator-metal (MIM).
8. A memory structure, as recited in clause 7, wherein the insulator in each of the first and second MIM is selected from the group consisting of: doped Si₃N₄, doped SiO₂, NiO, ZrO₂, HfO₂, TiO₂, Cu₂O, or PCMO.
9. A memory structure, as recited in clause 7, wherein the insulator in each of the first and second MIM is composed of a plurality of distinct insulating layers.
10. A memory structure, as recited in clause 7, wherein each of the metals in the MIM are made of a different composition.
11. A memory structure, as recited in clause 7, wherein the first and second diodes are composed of poly-crystalline silicon.
12. A memory structure, as recited in clause 7, wherein the insulator includes charge traps for nonvolatile trapping of charge
   wherein the trapped charge causes modulation of resistance.
13. A memory structure, as recited in clause 7, wherein the metal in each of the first and second MIM are each composed at least partially of: Pt, Ir, Pd, Ru, or Rh.
14. A memory structure, as recited in clause 1, wherein the first and second re-writable stacks are each made of metal-insulator-semiconductor (MIS).
15. A 3-dimensional memory arrangement made of memory trees positioned on top of semiconductor control circuitry comprising:
   at least one row of memory trees including a first type of memory tree;
   each tree having one tree trunk connecting a corresponding memory tree to the semiconductor control circuitry and each tree having a plurality of branches with at least one branch in each of a plurality of layers defining word lines in a plurality of layers, the word lines of a tree sharing a common vertical connection through the trunk of the tree to the semiconductor control circuitry;
   a plurality of bit lines in at least one layer formed substantially perpendicular to the word lines, each of the plurality of bit lines independently connected to the semiconductor control circuitry, each of the bit lines being shared by every tree in the row of memory trees; and
   a plurality of unipolar re-writable memory pillars in a plurality of layers formed at the intersections of word lines and bit lines.
16. A 3-dimensional memory arrangement, as recited in clause 15, wherein at least one word line extends on each opposite side of the trunk.
17. A 3-dimensional memory arrangement, as recited in clause 15, wherein each of the plurality of memory pillars includes a diode and a re-writable RRAM stack.
18. A 3-dimensional memory arrangement, as recited in clause 17, wherein diodes are composed of poly-crystalline silicon.
19. A 3-dimensional memory arrangement, as recited in clause 17, wherein the diodes of all of the memory pillars point in the same direction.
20. A 3-dimensional memory arrangement, as recited in clause 17, wherein each of the RRAM stacks is made of metal-insulator-metal (MIM).
21. A 3-dimensional memory arrangement, as recited in clause 17, wherein each of the RRAM stacks is made of metal-insulator-semiconductor (MIS).
22. A 3-dimensional memory arrangement, as recited in clause 15, wherein each trunk is made of tungsten.
23. A 3-dimensional memory arrangement, as recited in clause 15, wherein memory pillars are formed above and below the plurality of branches and including diodes, the diodes of the memory pillars formed on top of the plurality of branches point in a direction opposite to that of the diodes of the memory pillars formed below the plurality of branches.
24. A 3-dimensional memory arrangement, as recited in clause 15, wherein memory pillars are formed above and below the plurality of bit lines and including diodes, the diodes of the memory pillars formed on top of the plurality of bit lines point in a direction opposite to that of the diodes of the memory pillars formed below the plurality of bit lines.
25. A 3-dimensional memory arrangement, as recited in clause 15, wherein the at least one row of memory trees includes a second type of memory trees, said first and second types of memory trees positioned adjacent relative to each other.
26. A 3-dimensional memory arrangement, as recited in clause 25, wherein bit lines of said first and second types of memory trees are shared.
27. A 3-dimensional memory arrangement, as recited in clause 25, wherein word lines of said first and second types of memory trees are shared.
28. A 3-dimensional memory arrangement, as recited in clause 25, wherein bit lines and word lines of said first and second types of memory trees are shared.
29. A 3-dimensional memory arrangement, as recited in clause 25, wherein the first type of memory tree is offset from the second type of memory tree.
30. A 3-dimensional memory arrangement, as recited in clause 25, wherein the distance from the trunk of a first type of memory tree to the trunk of the next adjacent first type of memory tree is 4F.
31. A 3-dimensional memory arrangement, as recited in clause 25, wherein the second type of memory trees are a mirror image of the first type of memory trees.
32. A 3-dimensional memory arrangement, as recited in clause 25, wherein the arrangement includes a plurality of alternating first type and second type of memory trees.
33. A method of manufacturing a memory array having memory pillars comprising:
   depositing a conducting layer;
   first etching to form the first layer of bit lines or word lines;
   depositing a first SiO₂ layer;
   performing chemical mechanical planarization (CMP);
   depositing re-writable RRAM stack memory layers;
   depositing diode layers to form a diode having a first direction of current flow;
   second etching the deposited memory layers and diode layers;
   forming a pillar;
   depositing a second SiO₂ layer; and
   performing CMP.
34. A method of manufacturing a memory array, as recited in clause 33, further including depositing a barrier layer between the diode layers and the memory layers.
35. A method of manufacturing a memory array, as recited in clause 33, further including depositing a contact layer prior to the second etching step, to be used as a hard stop layer, and planarizing to the hard stop layer.
36. A method of manufacturing a memory array, as recited in clause 33, further including depositing a contact layer and a sacrificial hard stop layer prior to the second etching step, planarizing to the hard stop layer and etching to remove the hard stop layer.
37. A method of manufacturing a memory array, as recited in clause 33, further including the steps of:
   depositing a third SiO₂ layer prior to the step of depositing a conducting layer;
   planarizing the deposited third SiO₂ layer; and
   depositing an adhesion layer.
38. A method of manufacturing a memory array, as recited in clause 35, further including repeating the steps of clause 33 except replacing the depositing the diode layers step with the step of depositing diode layers to form a diode having a second direction of current flow opposite to that of the first current flow.
39. A memory structure comprising:
   a first memory pillar formed above a bit line and including,
      a first unipolar re-writable resistance random access memory (RRAM) stack;
      a first diode having a first direction of current flow and formed above the first stack; and
      a word line formed above the first memory pillar.
40. A memory structure, as recited in clause 39, wherein the re-writable stack is made of metal-insulator-metal (MIM).
41. A memory structure, as recited in clause 40, further including a second memory pillar formed above the word line and including,
   a second unipolar re-writable RRAM stack formed above the word line; and
   a second diode positioned to have a second direction of current flow being opposite to the first direction of current flow and formed above the second stack.

## Claims

1. A memory structure comprising:
vertically-stacked first and second memory pillars separated by a bit line or word line, the first pillar including,
a first diode having a first direction of current flow;
a first unipolar re-writable resistance random access memory (RRAM) stack formed below the first diode and above a bit line or word line separating the first and second pillars;
the second pillar including,
a second diode positioned to have a second direction of current flow being opposite to the first direction of current flow; and
a second unipolar re-writable RRAM stack formed below the second diode;
wherein the first and second re-writable stacks are each made of metal-insulator-metal (MIM).

2. A memory structure, as recited in claim 1, further including a first bit line formed above the first diode and a second bit line formed at the bottom of the second pillar and below the second stack.

3. A memory structure, as recited in claim 2, further including a first contact layer formed between the first diode and the first bit line and a second contact layer formed between the word line and second diode.

4. A memory structure, as recited in claim 3, further including a first adhesion layer formed between the first bit line and the first contact layer.

5. A memory structure, as recited in claim 2, further including a second adhesion layer formed below the second bit line.

6. A memory structure, as recited in claim 1, further including a first barrier layer formed between the first stack and the first diode and a second barrier layer formed between the second stack and the second diode.

7. A memory structure, as recited in claim 1, wherein the insulator in each of the first and second MIM is selected from the group consisting of: doped Si₃N₄, doped SiO₂, NiO, ZrO₂, HfO₂, TiO₂, Cu₂O, or PCMO.

8. A memory structure, as recited in claim 1, wherein the insulator in each of the first and second MIM is composed of a plurality of distinct insulating layers.

9. A memory structure, as recited in claim 1, wherein each of the metals in the MIM are made of a different composition.

10. A memory structure, as recited in claim 1, wherein the first and second diodes are composed of poly-crystalline silicon.

11. A memory structure, as recited in claim 1, wherein the insulator includes charge traps for nonvolatile trapping of charge
wherein the trapped charge causes modulation of resistance.

12. A memory structure, as recited in claim 1, wherein the metal in each of the first and second MIM are each composed at least partially of: Pt, Ir, Pd, Ru, or Rh.

13. A memory structure, as recited in claim 1, wherein the first and second re-writable stacks are each made of metal-insulator-semiconductor (MIS).

14. A memory structure comprising:
a first memory pillar formed above a bit line and including,
a first unipolar re-writable resistance random access memory (RRAM) stack;
a first diode having a first direction of current flow and formed above the first stack; and
a word line formed above the first memory pillar; wherein the re-writable stack is made of metal-insulator-metal (MIM).

15. A memory structure, as recited in claim 14, further including a second memory pillar formed above the word line and including,
a second unipolar re-writable RRAM stack formed above the word line; and
a second diode positioned to have a second direction of current flow being opposite to the first direction of current flow and formed above the second stack.
